# EUROPÄISCHE PATENTSCHRIFT

(11) **EP 2 938 797 B1**
(45) Veröffentlichungstag und Bekanntmachung des Hinweises auf die Patenterteilung: **15.04.2020**
(21) Anmeldenummer: 13852354.3
(22) Anmeldetag: 23.12.2013
(51) Int. Cl.: E05B 85/02

(54) **KOMPONENTENTRÄGER**
COMPONENT CARRIER
SUPPORT DE COMPOSANT

(30) Priorität: 27.12.2012 DE 202012105073 U
(43) Veröffentlichungstag der Anmeldung: 04.11.2015
(60) Teilanmeldung: 20154018.4
(73) Patentinhaber: Kiekert Aktiengesellschaft, 42579 Heiligenhaus (DE)
(72) Erfinder: KOCH, Asmus, 50678 Köln (DE); HEINZEN, Inga, 47807 Krefeld (DE); FASSEL, Jan, CZ-Nejdek 362 22 (CZ); SUK, Jan, CZ-Cechtice 257 65 (CZ)
(86) Internationale Anmeldenummer: PCT/DE2013/000822
(87) Internationale Veröffentlichungsnummer: WO 2014/106502

(56) Entgegenhaltungen:
- WO-A1-2009/010734
- DE-A1-102006 017 830
- DE-A1-102009 002 902
- DE-C1- 4 323 827
- DE-U1-202010 009 708

## Beschreibung

Die Erfindung betrifft einen Komponententräger für elektrische/elektronische Bauteile, beispielsweise zur Kombination mit einem Schlossgehäuse oder als Bestandteil eines Schlossgehäuses eines Kraftfahrzeugtürschlosses, mit einem Trägerelement und einem mit dem Trägerelement verbindbaren Leiterbahngebilde aus einzelnen metallischen Leiterbahnen.

Bei einem Komponententräger des eingangs beschriebenen Aufbaus entsprechend der DE 10 2005 049 975 C5 handelt es sich um ein Schlossgehäuse eines Kraftfahrzeugtürverschlusses. Dieses weist wenigstens ein Basiselement auf. Das Leiterbahngebilde ist aus Weißblech hergestellt, bei welchem es sich um ein kaltgewalztes Stahlblech mit einer Dicke von bis zu 0,5 mm handelt. Außerdem ist eine weißschimmernde Zinnschicht von mindestens 5 µm elektrolytisch aufgebracht. Auf diese Weise wird eine kostengünstige und robuste Auslegung eines Komponententrägers zur Verfügung gestellt.

Vergleichbare Komponententräger werden in der DE 101 39 356 A1 oder auch der DE 20 2010 009 708 U1 beschrieben.

Wie üblich dient der Komponententräger dazu, elektrische und/oder elektronische Bauteile auf seinem Trägerelement aufzunehmen und mit Hilfe des Leiterbahngebildes untereinander bzw. mit einer entfernten Steuereinheit oder anderen elektrischen Elementen zu verbinden. Zu diesem Zweck wird der gesamte Komponententräger nach der Bestückung mit den elektrischen bzw. elektronischen Bauteilen typischerweise mit einer Vergussmasse umhüllt, um ihn vor Umwelteinflüssen zu schützen. Bei dem Leiterbahngebilde handelt es sich regelmäßig um ein Stanzgitter, welches die verschiedenen Leiterbahnen zusammenfasst und deren gemeinsame Herstellung ermöglicht. Zusammen mit dem Trägerelement bzw. den elektrischen/elektronischen Bauteilen wird das Leiterbahngebilde nach der Bestückung durch die Vergussmasse größtenteils oder gänzlich verschlossen. Diese Vorgehensweise hat sich prinzipiell bewährt.

Im Stand der Technik bzw. in der Praxis wird generell das Ziel verfolgt, die Materialstärke des eingesetzten Leiterbahngebildes aus Kostengründen so gering wie möglich einzustellen. Die gattungsbildende Lehre entsprechend der DE 10 2005 049 975 C5 arbeitet an dieser Stelle mit Weißblech einer Dicke von lediglich bis zu 0,5 mm. Dem Trend zur Materialersparnis zuwider treten jedoch mit immer geringer werdender Materialstärke zunehmend Montageprobleme auf. Tatsächlich treten insbesondere bei der Kontaktierung von Motoren oder anderen voluminösen und gewichtigen elektrischen bzw. elektronischen Bauteilen mit dem Leiterbahngebilde Probleme dergestalt auf, dass abgewinkelte Fahnen des Leiterbahngebildes unbeabsichtigt umgebogen werden. Das kann sogar noch während des Betriebes durch zwangsläufige Bewegungen des Motors auftreten. Als Folge hiervon werden in der Praxis Kontaktprobleme beobachtet, die insbesondere nach einer bestimmten Betriebszeit besonders problematisch sind und nur aufwendig beherrscht werden können. Hier will die Erfindung insgesamt Abhilfe schaffen.

DE 43 23 827 C1 und WO 2009 010 734 A1 beschreiben jeweils einen Komponententräger mit einem Komponententräger mit einem Trägerelement und einem mit dem Trägerelement verbindbaren Leiterbahngebilde aus einzelnen metallischen Leiterbahnen, wobei sich das Leiterbahngebilde aus wenigstens zwei Leiterbahnteilgebilden mit jeweils unterschiedlicher Materialstärke der zugehörigen Leiterbahnen zusammensetzt.

Vor diesem Hintergrund schlägt die Erfindung den Gegenstand des Anspruchs 1 vor. Der erfindungsgemäße Komponententräger ermöglicht es, dass aktuelle und zukünftige Kontaktprobleme praktisch nicht mehr auftreten und eine dauerhaft einwandfreie Funktionsweise gewährleistet ist.

Im Rahmen der Erfindung ist also das Leiterbahngebilde wenigstens zweiteilig oder zweigeteilt ausgelegt. Tatsächlich sind zumindest zwei Leiterbahnteilgebilde realisiert, die jeweils eine unterschiedliche Materialstärke der zugehörigen Leiterbahnen aufweisen. Bei den beiden Leiterbahnteilgebilden handelt es sich erfindungsgemäß um ein Schalterleiterbahngebilde vorgegebener Materialstärke und zusätzlich ein Motorleiterbahngebilde mit größerer Materialstärke im Vergleich zum Schalterleiterbahngebilde. Der Komponententräger weist ein eine Motoraufnahme oder Motorwanne aufweisendes Trägerelement auf, und das Motorleiterbahngebilde ist zur Kontaktierung eines in die Motoraufnahme oder Motorwanne plazierbaren Elektromotors ausgebildet.

Das heißt, die jeweiligen Leiterbahnen des Motorleiterbahngebildes weisen eine größere Materialstärke als die Leiterbahnen des Schalterleiterbahngebildes auf. Dabei ist die Auslegung insgesamt so getroffen, dass die jeweiligen Leiterbahnen einerseits des Schalterleiterbahngebildes und andererseits des Motorleiterbahngebildes eine durchgängig gleiche Materialstärke besitzen. Denn grundsätzlich könnte auch innerhalb des jeweiligen Leiterbahnteilgebildes mit verschiedenen Materialstärken gearbeitet werden. Im Rahmen der Erfindung ist jedoch die Auslegung so getroffen, dass die jeweiligen Leiterbahnen des Schalterleiterbahngebildes eine geringere Materialstärke als die jeweiligen Leiterbahnen des Motorleiterbahngebildes aufweisen. Durch diese Auslegung wird den unterschiedlichen mechanischen Beanspruchungen sowohl bei der Montage als auch dem Betrieb Rechnung getragen. Denn das Schalterleiterbahngebilde dient typischerweise dazu, Schalter, Sensoren, Relais oder andere elektrische/elektronische Bauteile mit geringem Gewicht und kleinen Dimensionen zu kontaktieren, die darüber hinaus während des Betriebes auch keine Eigenbewegungen vollführen. Folglich reicht es für die jeweiligen Leiterbahnen des Schalterleiterbahngebildes aus, dass diese über eine geringere Materialstärke verfügen, die in der Regel 0,5 mm unterschreitet, meistens sogar 0,4 mm oder sogar weniger beträgt.

Demgegenüber dient das Motorleiterbahngebilde zur Kontaktierung elektrischer bzw. elektronischer Bauteile mit demgegenüber größerem Gewicht und zwar zumindest Elektromotoren, die während des Betriebes eine Eigenbewegung vollführen. An dieser Stelle kommt es darauf an, dass zugehörige Leiterfahnen bzw. das Motorleiterbahngebilde insgesamt steif ausgelegt ist und die Leiterfahnen nicht zum Abknicken, Abbrechen etc. neigen. Aus diesem Grund sind die jeweiligen Leiterbahnen des Motorleiterbahngebildes typischerweise mit einer in etwa doppelten Materialstärke im Vergleich zu den Leiterbahnen des Schalterleiterbahngebildes ausgerüstet. Meistens beträgt die Materialstärke ca. 0,8 mm und mehr.

Auf diese Weise ist das erfindungsgemäße Leiterbahngebilde mit den beiden Leiterbahnteilgebilden bzw. dem Schalterleiterbahngebilde und dem Motorleiterbahngebilde individuell an die jeweils zu kontaktierenden elektrischen/elektronischen Bauelemente angepasst. So erfahren elektrische/elektronische Gebilde mit geringem Gewicht und ohne Eigenbewegung typischerweise eine Kontaktierung durch das Schalterleiterbahngebilde, wobei dieses dem Verwendungszweck dadurch Rechnung trägt, dass hier mit geringen Materialstärken im Bereich von ca. 0,4 mm bis 0,5 mm gearbeitet wird und auch gearbeitet werden kann. Dadurch ist eine signifikante Materialersparnis gegenüber einem Leiterbahngebilde aus beispielsweise Leiterbahnen mit einer jeweiligen Materialstärke von ca. 0,8 mm gegeben.

Demgegenüber verfügt das unabhängige Motorleiterbahngebilde über eine größere Materialstärke der jeweiligen Leiterbahnen, die typischerweise oberhalb von 0,7 mm und insbesondere bei 0,8 mm und mehr angesiedelt ist. Dadurch weist das Motorleiterbahngebilde per se eine signifikante Steifigkeit auf und neigen insbesondere Leiterfahnen bei der Kontaktierung mit beispielsweise Elektromotoren nicht zum Abknicken oder Abbrechen. Ein solches Abknicken oder Abbrechen wird auch nicht während des Betriebes beobachtet, so dass die Kontaktierung der an das Motorleiterbahngebilde typischerweise angeschlossenen Elektromotoren dauerhaft und einwandfrei über die gesamte Lebensdauer besteht und eingerichtet ist.

Das Schalterleiterbahngebilde verfügt über eine flächenmäßige Ausdehnung, die typischerweise ein Vielfaches der flächenmäßigen Ausdehnung des Motorleiterbahngebildes beträgt. Das lässt sich darauf zurückführen, dass der erfindungsgemäße Komponententräger zur Kombination mit oder als Bestandteil des Schlossgehäuses eines Kraftfahrzeugtürverschlusses eine Vielzahl von Schaltern, Sensoren etc. aufnimmt, allerdings regelmäßig nur ein oder zwei Motoren mit Hilfe des Motorleiterbahngebildes kontaktiert werden müssen. Aus diesem Grund fällt die größere Materialstärke des Motorleiterbahngebildes im Vergleich zu derjenigen des Schalterleiterbahngebildes nicht wesentlich ins Gewicht und das erfindungsgemäße Leiterbahngebilde kann zu vergleichbaren Kosten hergestellt werden wie bisherige Leiterbahngebilde bei zugleich verbesserter und dauerhafter Funktionalität.

Hierzu trägt ergänzend der Umstand bei, dass die beiden Leiterbahngebilde typischerweise aus unterschiedlichen Metallen gefertigt sind. So empfiehlt die Erfindung für die Herstellung des Schalterleiterbahngebildes ein regelmäßig kalt verformbares Material wie beispielsweise Messing. Auf diese Weise kann die Kontaktierung und der Anschluss der Schalter, Sensoren etc. einfach und problemlos mit dem Schalterleiterbahngebilde erfolgen. Demgegenüber ist das Motorleiterbahngebilde typischerweise aus einem warmverformbaren Metall wie beispielsweise Weißblech hergestellt. Dadurch verfügt das Motorleiterbahngebilde per se über eine große und ausreichende Steifigkeit, um insbesondere Elektromotoren ohne Abknicken, Abbrechen etc. etwaiger Leiterfahnen kontaktieren und betreiben zu können. Bei dem eingesetzten Weißblech handelt es sich typischerweise um ein kaltgewalztes Stahlblech, welches darüber hinaus eine Zinnschicht von mindestens 5 µm Schichtdicke aufweist. Die Zinnschicht mag elektrolytisch aufgebracht sein, wie dies in der den gattungsbildenden Stand der Technik repräsentierenden DE 10 2005 049 975 C5 im Detail beschrieben wird.

Auf diese Weise verfügt das erfindungsgemäße Leiterbahngebilde insgesamt über die erforderliche korrosionsgeschützte Auslegung, die bei dem Schalterleiterbahngebilde aus Messing ohnehin gegeben ist und bei dem Motorleiterbahngebilde durch die Beschichtung mit Zinn zur Verfügung gestellt wird. Hinzu kommt, dass das Motorleiterbahngebilde durch die Beschichtung mit Zinn einfach mit Hilfe von säurefreien Flussmitteln elektrisch lötbar ist, so dass die angesprochenen Elektromotoren problemlos und dauerhaft mit dem Motorleiterbahngebilde elektrisch verbunden werden können. Für das Schalterleiterbahngebilde aus Messing gilt dies von vorneherein und ohne zusätzliche Bearbeitungsschritte, eine Beschichtung etc.

Im Regelfall sind beide Leiterbahngebilde als jeweils Stanzteile ausgelegt. Die Herstellung der beiden Leiterbahngebilde kann getrennt oder auch gemeinsam erfolgen. In letztgenanntem Fall handelt es sich bei den beiden Leiterbahngebilden um ein kombiniertes Komplettleiterbahngebilde, welche anschließend mit dem Komponententräger vereinigt wird. Für den Fall, dass die beiden Leiterbahnteilgebilde getrennt voneinander hergestellt werden, empfiehlt es sich, beide Leiterbahnteilgebilde jeweils separat mit dem Komponententräger zu vereinigen.

Aufgrund der dargestellten und eingesetzten verschiedenen Materialien für einerseits das Schalterleiterbahngebilde und andererseits das Motorleiterbahngebilde werden auch unterschiedliche Härten beobachtet. Tatsächlich verfügt das Schalterleiterbahngebilde aus regelmäßig Messing über eine Brinellhärte von in etwa 35 bis 200 HB. Demgegenüber ist das Motorleiterbahngebilde aus beispielsweise Weißblech mit einer Rockwellhärte im Bereich zwischen 48 HR bis 56 HR ausgerüstet. Durch diese unterschiedliche Auslegung wird ergänzend deutlich, dass das Motorleiterbahngebilde besonders robust und dauerhaft ausgelegt ist, während das Schalterleiterbahngebilde zugunsten einer deutlichen Materialersparnis und wegen der geringen mechanischen Belastung bei der Kontaktierung und im Betrieb eine eher filigrane Gestaltung aufweist. Durch diese kombinatorische Wirkung und die jeweilige Anpassung an den tatsächlichen Anwendungszweck wird erstmals eine signifikante Materialersparnis zugleich mit hoher Funktionssicherheit kombiniert. Hierin sind die wesentlichen Vorteile zu sehen.

Im Folgenden wird die Erfindung anhand einer lediglich ein Ausführungsbeispiel darstellenden Zeichnung näher erläutert; es zeigen:
- Fig. 1: einen erfindungsgemäßen Komponententräger für elektrische/elektronische Bauteile in Gestalt eines Schlossgehäuses eines Kraftfahrzeugtürverschlusses perspektivisch und
- Fig. 2: das im Rahmen der Fig. 1 verwendete Leiterbahngebilde in einer Einzelansicht.

In den Figuren ist ein Komponententräger für elektrische/elektronische Bauteile 1, 2, 3 dargestellt. Bei dem Komponententräger handelt es sich im Beispielfall um den Bestandteil eines Schlossgehäuses 4 eines nicht näher gezeigten Kraftfahrzeugtürverschlusses, welches insofern als Trägerelement 4 fungiert. Grundsätzlich kann der Komponententräger aber auch unabhängig von dem Schlossgehäuse 4 in dessen Innern aufgenommen und platziert werden. Das ist jedoch nicht dargestellt. Das heißt, im Rahmen des Ausführungsbeispiels sind das Trägerelement 4 und das Schlossgehäuse 4 synonym bzw. stellt der Komponententräger einen Bestandteil des Schlossgehäuses 4 des fraglichen Kraftfahrzeugtürverschlusses dar, wobei das Schlossgehäuse 4 ganz oder teilweise als Trägerelement 4 des Komponententrägers fungiert.

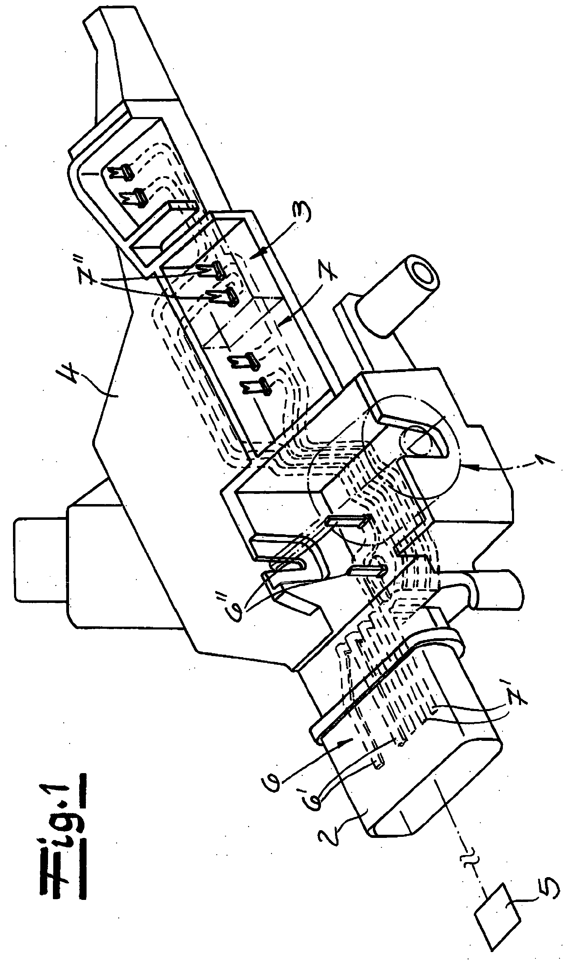

Bei den elektrischen/elektronischen Bauteilen 1, 2, 3 handelt es sich um einen nur angedeuteten Elektromotor 1, der in einer zugehörigen Motoraufnahme oder Motorwanne platziert ist. Darüber hinaus erkennt man in der Fig. 1 ansatzweise eine Buchse 2 zur Aufnahme eines nicht dargestellten Steckers, mit dessen Hilfe die fraglichen elektrischen/elektronischen Bauteile 1, 2, 3 mit einer entfernt angeordneten und lediglich angedeuteten Steuereinheit 5 elektrisch verbunden werden.

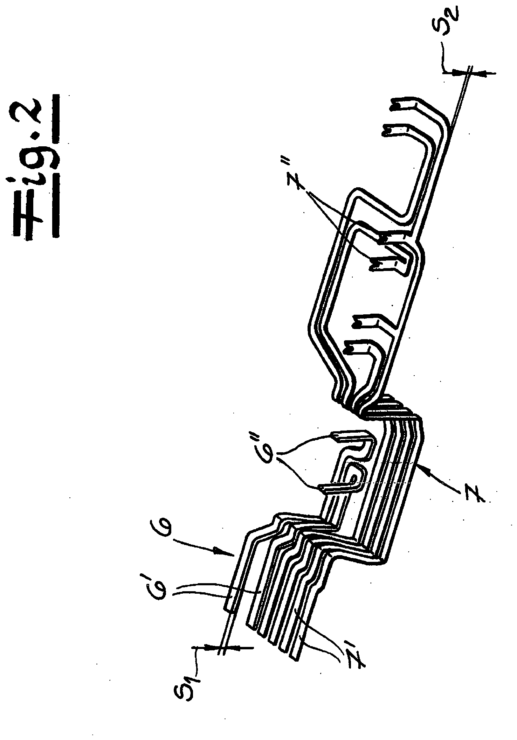

Bei dem elektrischen bzw. elektronischen Bauteil 3 handelt es sich schließlich um einen Mikroschalter 3, der in der Fig. 1 exemplarisch angedeutet ist und beispielsweise einzelne Funktionsstellungen von mechanischen Elementen des Kraftfahrzeugtürverschlusses abfragt. Die zuvor erläuterten und nur beispielhaft sowie nicht abschließend dargestellten und beschriebenen elektrischen/elektronischen Bauteile 1, 2, 3 werden insgesamt von dem Schlossgehäuse 4 getragen bzw. aufgenommen, das diesbezüglich als Trägerelement 4 fungiert. Mit dem Trägerelement 4 ist ein im Detail in der Fig. 2 dargestelltes Leiterbahngebilde 6, 7 verbindbar. Das Leiterbahngebilde 6, 7 setzt sich aus einzelnen Leiterbahnen 6' bzw. 7' zusammen.

Die Verbindung zwischen dem Schlossgehäuse bzw. Trägerelement 4 und dem Leiterbahngebilde 6, 7 kann in herkömmlicher Art und Weise derart geschehen, dass zunächst das Leiterbahngebilde 6, 7 auf oder in das Schlossgehäuse 4 eingelegt und dann eine Vorfixierung mit Hilfe von Vergussmasse bzw. unter Rückgriff auf ein Adhäsivmittel erfährt. Nach dieser Vorfixierung werden die elektrischen/elektronischen Bauteile 1, 2, 3 mit dem Leiterbahngebilde 6, 7 bzw. von dem Leiterbahngebilde 6, 7 jeweils hochstehenden Leiterfahnen 6" bzw. 7" kontaktiert (vgl. Fig. 2). Das kann durch simples Aufstecken von Kontakten, durch Verlöten etc. erfolgen.

Damit bei diesem Montagevorgang etwaige Leiterfahnen 6" bzw. 7" nicht abknicken oder im Betrieb abknicken oder sogar abbrechen, ist das aus den einzelnen metallischen Leiterbahnen 6, 7 zusammengesetzte Leiterbahngebilde 6, 7 erfindungsgemäß aus zwei Leiterbahnteilgebilden 6; 7 mit jeweils unterschiedlicher Materialstärke s₁, s₂ der zugehörigen Leiterbahnen 6, 7 zusammengesetzt. Tatsächlich beträgt die Materialstärke s₁ des ersten Leiterbahngebildes 6 typischerweise mehr als 0,7 mm, ist im Ausführungsbeispiel bei ca. 0,8 mm angesiedelt. Demgegenüber liegt die Materialstärke s₂ des zweiten Leiterbahngebildes 7 typischerweise unterhalb von 0,5 mm, beträgt nach dem Ausführungsbeispiel ca. 0,4 mm.

Bei dem ersten Leiterbahngebilde 6 handelt es sich im Ausführungsbeispiel um ein Motorleiterbahngebilde 6. Der Name Motorleiterbahngebilde 6 resultiert nach dem Ausführungsbeispiel daher, dass mit Hilfe dieses ersten Leiterbahnteilgebildes bzw. Motorleiterbahngebildes 6 der wenigstens eine Elektromotor 1 kontaktiert wird. Durch die relativ große Materialstärke s₁ des fraglichen Motorleiterbahngebildes 6 im Bereich von 0,7 mm und mehr werden bei der Kontaktierung des fraglichen Elektromotors 1 etwaige Umbiegungen, Abbiegungen oder ein Abbrechen der zugehörigen Leiterfahnen 6" erfindungsgemäß vermieden.

Außerdem trägt die hierdurch erreichte Steifigkeit des Motorleiterbahngebildes 6 dem Umstand Rechnung, dass der Elektromotor 1 im Betrieb Eigenbewegungen vollführt, im Regelfall um seine Achse rotiert und hierdurch beispielsweise eine Antriebsschnecke verschwenkt. Solche Eigenbewegungen des Elektromotors 1 werden aufgrund der signifikanten Materialstärke s₁ des zugehörigen Motorleiterbahngebildes 6 problemlos aufgenommen, ohne dass die zugehörige Leiterfahne 6" - auch im Betrieb - abknickt, abreißt etc.

Hierzu trägt ergänzend der Umstand bei, dass das Motorleiterbahngebilde 6 nach dem Ausführungsbeispiel aus einem warmverformbaren Material wie Weißblech hergestellt ist. Dabei kann wie in der DE 10 2005 049 975 C5 beschrieben ein kaltgewalztes Stahlblech mit der angegebenen Materialstärke s₁ von wenigstens 0,7 mm zum Einsatz kommen, das darüber hinaus mit einer Zinnschicht von mindestens 5 µm Stärke ausgerüstet ist, um etwaige Korrosionen zu verhindern und die Kontaktierung zu erleichtern. Die Funktionssicherheit ist also über die gesamte Lebensdauer des dargestellten Kraftfahrzeugtürverschlusses gegeben.

Demgegenüber ist das zweite Leiterbahnteilgebilde 7 mit der geringeren Materialstärke s₂ von typischerweise weniger als 0,5 mm und nach dem Ausführungsbeispiel von ca. 0,4 mm ausgerüstet. Aufgrund dieser geringen Materialstärke s₂ handelt es sich vorliegend um ein Schalterleiterbahngebilde 7, welches regelmäßig aus einem kaltverformbaren Material wie beispielsweise Messing hergestellt ist. Aus diesem Grund lassen sich die zugehörigen Leiterfahnen 7" im Bedarfsfall auch (geringfügig) von Hand verbiegen. Dadurch kann der Mikroschalter 3 im Beispielfall problemlos angeschlossen und beispielsweise an die zugehörige Leiterfahne 7" angelötet werden.

Anhand der Fig. 2 erkennt man, dass die beiden Leiterbahnteilgebilde 6, 7 grundsätzlich als kombiniertes Komplettleiterbahngebilde 6, 7 mit dem Trägerelement 4 vereinigt werden können. Nach dem Ausführungsbeispiel handelt es sich jedoch um zwei separat gefertigte und mit dem Trägerelement 4 vereinigbare Leiterbahnteilgebilde 6; 7. Das heißt, das jeweilige Leiterbahnteilgebilde 6; 7 wird zunächst mit dem Trägerelement 4 vereinigt und erfährt die beschriebene Vorfixierung. Danach werden die elektrischen Bauteile 1, 2, 3 mit dem gesamten Leiterbahngebilde 6, 7 bzw. den einzelnen Leiterbahnteilgebilden 6, 7 elektrisch verbunden. Im Anschluss daran wird der gesamte Komponententräger mit der Vergussmasse endvergossen und komplett mediendicht verschlossen.

## Patentansprüche

1. Komponententräger für elektrische/elektronische Bauteile (1, 2, 3), beispielsweise zur Kombination mit einem Schlossgehäuse (4) oder als Bestandteil eines Schlossgehäuses (4) eines Kraftfahrzeugtürverschlusses, mit
- einem eine Motoraufnahme oder Motorwanne aufweisenden Trägerelement (4) und
- einem mit dem Trägerelement (4) verbindbaren Leiterbahngebilde (6, 7) aus einzelnen metallischen Leiterbahnen (6, 7), das sich aus wenigstens zwei Leiterbahnteilgebilden (6; 7) mit jeweils unterschiedlicher Materialstärke (s₁; s₂) der zugehörigen Leiterbahnen (6, 7) zusammensetzt; wobei
- das eine Leiterbahnteilgebilde (7) als Schalterleiterbahngebilde (7) vorgegebener Materialstärke (s₂) und das andere Leiterbahngebilde (6) als Motorleiterbahngebilde (6) mit größerer Materialstärke (s₁) der jeweiligen Leiterbahnen (6, 7) ausgebildet ist, und
- das Motorleiterbahngebilde (6) zur Kontaktierung eines in die Motoraufnahme oder Motorwanne plazierbaren Elektromotor ausgebildet ist.

2. Komponententräger nach dem vorigen Anspruch, **dadurch gekennzeichnet, dass**
- die beiden Leiterbahnteilgebilde (6, 7) aus unterschiedlichen Metallen gefertigt sind.

3. Komponententräger nach einem der vorigen Ansprüche, **dadurch gekennzeichnet, dass**
- das Schalterleiterbahngebilde (7) aus einem kaltverformbaren Metall wie beispielsweise Messing hergestellt ist.

4. Komponententräger nach einem der vorigen Ansprüche, **dadurch gekennzeichnet, dass**
- das Motorleiterbahngebilde (6) aus einem warmverformbaren Material wie beispielsweise Weißblech hergestellt ist.

5. Komponententräger nach einem der vorigen Ansprüche, **dadurch gekennzeichnet, dass**
- das Motorleiterbahngebilde (6) eine in etwa doppelt so große Materialstärke (s₁ ≈ 2 s₂) im Vergleich zum Schalterleiterbahngebilde (7) aufweist.

6. Komponententräger nach einem der vorigen Ansprüche, **dadurch gekennzeichnet, dass**
- die Materialstärke (s₁) des Motorleiterbahngebildes zumindest 0,7 mm und insbesondere 0,8 mm und mehr beträgt.

7. Komponententräger nach einem der vorigen Ansprüche, **dadurch gekennzeichnet, dass**
- die Materialstärke (s₂) des Schalterleiterbahngebildes (7) weniger als 0,5 mm und insbesondere 0,4 mm und weniger beträgt.

8. Komponententräger nach einem der vorigen Ansprüche, **dadurch gekennzeichnet, dass**
- die beiden Leiterbahnteilgebilde (6; 7) als jeweils Stanzteile ausgelegt sind.

9. Komponententräger nach einem der vorigen Ansprüche, **dadurch gekennzeichnet, dass**
- das Motorleiterbahngebilde (6) einen Härtegrad im Bereich von 48 HR bis 56 HR aufweist.

10. Komponententräger nach einem der vorigen Ansprüche, **dadurch gekennzeichnet, dass**
- das Schalterleiterbahngebilde (7) einen Härtegrad im Bereich von 35 bis 200 HB besitzt.

11. Komponententräger nach einem der vorigen Ansprüche, **dadurch gekennzeichnet, dass**
- die beiden Leiterbahnteilgebilde (6; 7) als kombiniertes Komplettleiterbahngebilde (6; 7) mit dem Komponententräger (4) oder jeweils separat mit dem Komponententräger (4) vereinigt werden.

## Claims

1. Component carrier for electrical/electronic components (1, 2, 3), for example to be combined with a latch housing (4) or as part of a latch housing (4) of a motor vehicle door lock, comprising
- a carrier element (4) having a motor receptacle or motor cradle, and
- a conductor track structure (6, 7) which is made of individual metal conductor tracks (6, 7), can be connected to the carrier element (4) and consists of at least two partial conductor track structures (6; 7) each having a different material thickness (s₁; s₂) of the associated conductor tracks (6, 7);
wherein
- one partial conductor track structure (7) is designed as a switch conductor track structure (7) of a specified material thickness (s₂) and the other conductor track structure (6) is designed as a motor conductor track structure (6) having a greater material thickness (s₁) of the respective conductor tracks (6, 7), and
- the motor conductor track structure (6) is designed to contact an electric motor that can be placed in the motor receptacle or motor cradle.

2. Component carrier according to the preceding claim, **characterized in that**
- the two partial conductor track structures (6, 7) are made of different metals.

3. Component carrier according to either of the preceding claims, **characterized in that**
- the switch conductor track structure (7) is produced from a cold-formable metal such as brass.

4. Component carrier according to any of the preceding claims, **characterized in that**
- the motor conductor track structure (6) is produced from a hot-formable material such as tinplate.

5. Component carrier according to any of the preceding claims, **characterized in that**
- the motor conductor track structure (6) has a material thickness approximately twice as large (s₁ ≈ 2s₂) in comparison to the switch conductor track structure (7).

6. Component carrier according to any of the preceding claims, **characterized in that**
- the material thickness (s₁) of the motor conductor track structure is at least 0.7 mm and in particular is 0.8 mm or more.

7. Component carrier according to any of the preceding claims, **characterized in that**
- the material thickness (s₂) of the switch conductor track structure (7) is less than 0.5 mm and in particular is 0.4 mm or less.

8. Component carrier according to any of the preceding claims, **characterized in that**
- the two partial conductor track structures (6; 7) are each designed as stamped parts.

9. Component carrier according to any of the preceding claims, **characterized in that**
- the motor conductor track structure (6) has a degree of hardness in the range of from 48 HR to 56 HR.

10. Component carrier according to any of the preceding claims, **characterized in that**
- the switch conductor track structure (7) has a degree of hardness in the range of from 35 to 200 HB.

11. Component carrier according to any of the preceding claims, **characterized in that**
- the two partial conductor track structures (6; 7) are connected to the component carrier (4) as a combined complete conductor track structure (6; 7) or are each connected separately to the component carrier (4).

## Revendications

1. Support de composants pour pièces électriques/électroniques (1, 2, 3), par exemple destiné à être combiné à un boîtier de serrure (4) ou à constituer une partie d'un boîtier de serrure (4) d'un système de fermeture de porte de véhicule automobile, comportant
- un élément de support (4) présentant un logement de moteur ou un carter de moteur, et
- une structure de pistes conductrices (6, 7) pouvant être connectée à l'élément de support (4) et constituée de pistes conductrices métalliques individuelles (6, 7), laquelle se compose d'au moins deux sous-structures de pistes conductrices (6 ; 7), les pistes conductrices correspondantes (6, 7) présentant respectivement des épaisseurs de matériau différentes (s₁ ; s₂) ;
dans lequel
- ladite sous-structure de piste conductrice (7) est conçue sous forme de structure de piste conductrice de commutateur (7) d'épaisseur de matériau prédéterminée (s₂), et l'autre structure de piste conductrice (6) est conçue sous forme de structure de piste conductrice de moteur (6) comportant une épaisseur de matériau (s₁) plus élevée des pistes conductrices respectives (6, 7), et
- la structure de piste conductrice de moteur (6) est conçue pour entrer en contact avec un moteur électrique pouvant être placé dans le logement de moteur ou dans le carter de moteur.

2. Support de composants selon la revendication précédente, **caractérisé en ce que**
- les deux sous-structures de pistes conductrices (6, 7) sont réalisées en métaux différents.

3. Support de composants selon l'une quelconque des revendications précédentes, **caractérisé en ce que**
- la structure de piste conductrice de commutateur (7) est fabriquée en un métal déformable à froid tel que du laiton.

4. Support de composants selon l'une quelconque des revendications précédentes, **caractérisé en ce que**
- la structure de piste conductrice de moteur (6) est fabriquée en un matériau thermoformable tel que du fer blanc.

5. Support de composants selon l'une quelconque des revendications précédentes, **caractérisé en ce que**
- la structure de piste conductrice de moteur (6) comprend une épaisseur de matériau environ deux fois plus élevée (s₁ ≈ 2s₂) que celle de la structure de piste conductrice de commutateur (7).

6. Support de composants selon l'une quelconque des revendications précédentes, **caractérisé en ce que**
- l'épaisseur de matériau (s₁) de la structure de piste conductrice de moteur est d'au moins 0,7 mm, et en particulier supérieure ou égale à 0,8 mm.

7. Support de composants selon l'une quelconque des revendications précédentes, **caractérisé en ce que**
- l'épaisseur de matériau (s₂) de la structure de piste conductrice de commutateur (7) est inférieure à 0,5 mm, et en particulier inférieure ou égale à 0,4 mm.

8. Support de composants selon l'une quelconque des revendications précédentes, **caractérisé en ce que**
- les deux sous-structures de pistes conductrices (6 ; 7) se présentent respectivement sous la forme de pièces embouties.

9. Support de composants selon l'une quelconque des revendications précédentes, **caractérisé en ce que**
- la structure de piste conductrice de moteur (6) comprend un degré de dureté compris entre 48 HR et 56 HR.

10. Support de composants selon l'une quelconque des revendications précédentes, **caractérisé en ce que**
- la structure de piste conductrice de commutateur (7) présente un degré de dureté compris entre 35 et 200 HB.

11. Support de composants selon l'une quelconque des revendications précédentes, **caractérisé en ce que**
- les deux sous-structures de pistes conductrices (6 ; 7) sont associées au support de composants (4) sous forme de structure de pistes conductrices complète combinée (6 ; 7) ou sont associées au support de composants (4) chacune séparément.
